# FASCICULE DE BREVET EUROPEEN

(11) **EP 0 978 024 B1**
(45) Date de publication et mention de la délivrance du brevet: **20.03.2002**
(21) Numéro de dépôt: 97929336.2
(22) Date de dépôt: 11.06.1997
(51) Int. Cl.: G06F 1/20

(54) **DISPOSITIF DE SORTIE D'AIR POUR UNE UNITE CENTRALE DE MICRO-ORDINATEUR**
LUFTAUSLASSVORRICHTUNG FÜR EINE MIKROCOMPUTER-ZENTRALEINHEIT
AIR OUTLET DEVICE FOR A MICROCOMPUTER CPU

(30) Priorité: 11.06.1996 FR 9607222
(43) Date de publication de la demande: 09.02.2000
(73) Titulaire: Bodin, Eric, 14200 Herouville Saint Clair Cedex (FR)
(72) Inventeur: Bodin, Eric, 14200 Herouville Saint Clair Cedex (FR)
(74) Mandataire: Verdier, Louis
(86) Numéro de dépôt international: FR9701040
(87) Numéro de publication internationale: WO9748036

(56) Documents cités:
- DE-A- 4 111 333
- US-A- 5 193 523
- PATENT ABSTRACTS OF JAPAN vol. 018, no. 230 (E-1542), 26 avril 1994 & JP 06 021674 A (NEC CORP), 28 janvier 1994,
- PATENT ABSTRACTS OF JAPAN vol. 015, no. 128 (C-0818), 28 mars 1991 & JP 03 012107 A (SANWA GINKOU:KK;OTHERS: 01), 21 janvier 1991,
- DVORACK PAUL J.: "Packaging computers to survive in the real world" MACHINE DESIGN, vol. 60, no. 12, 26 mai 1988, CLEVELAND, OHIO, US, pages 70-76, XP002024255

## Description

La présente invention concerne un dispositif de sortie d'air d'une unité centrale de micro-ordinateur.

Les sorties d'air de ventilation des micro-ordinateurs, surtout lorsque les micro-ordinateurs sont utilisés en grand nombre, constituent une gêne pour les personnes se trouvent placées devant les sorties d'air, par exemple lorsque de nombreux micro-ordinateurs sont regroupés.

Les quantités importantes d'air mises en circulation pour la ventilation des micro-ordinateurs constituent également une source non négligeable de pollution car cet air remue de la poussière et des germes.

Il existe certes des solutions de fortune consistant à fixer par un ruban adhésif un morceau de papier devant la sortie d'air pour constituer un déflecteur soulevé par la poussée de l'air. Toutefois, cette solution n'est pas satisfaisante car elle ne permet pas de diriger l'air et par ailleurs elle ne nettoie pas le flux d'air chargé de poussières et de particules.

Le document "Patent Abstracts Of Japan" qui est un résumé du brevet japonais No. 6021674, concerne un couvercle 5 dont la surface 3 peut couvrir toute une zone de fentes de ventilation 2 réalisées dans le boîtier 7 d'un micro-ordinateur ou équipement analogue. Ce dispositif ne comporte pas de support se fixant autour de l'orifice de sortie d'air de ventilation. Il ne comporte pas non plus de tube de guidage et a fortiori, de tube orientable relié au support. Enfin, il n'est pas prévu de filtre à air ni de filtre à air amovible.

Le document "Patent Abstracts Of Japan" qui est un résumé du brevet japonais No. 03012107, concerne une sortie d'air pour un comptoir. Cette sortie est prévue du côté du public et non du côté de l'opérateur.

Le document US 5 193 523 A(DENBER) décrit un dispositif de chauffage du clavier ou plus généralement du poste de travail d'un opérateur en informatique. La sortie d'air de l'unité centrale est reliée par un tuyau au clavier, soit par en dessous, soit par au-dessus.

Le document DE 41 11 333 A(GARTNER) concerne un dispositif pour évacuer la chaleur dégagée par des appareils électriques. Comme l'indique le résumé visé dans le rapport de recherche, il s'agit d'éviter le chauffage de locaux par la chaleur dégagée par des appareils électriques. Pour cela, ce document prévoit un dispositif pour évacuer cette chaleur. Selon ce dispositif, les boîtiers des appareils sont reliés à des tuyaux d'aspiration, eux-mêmes reliés à des installations d'aspiration éloignées des appareils électriques à un emplacement non visible. Puis, l'air chaud est évacué à l'extérieur.

Il ne s'agit pas dans ce cas de dévier un jet d'air sortant d'une unité centrale mais d'un système de ventilation.

Le document MACHINE DESIGN, vol. 60, No. 12, 26 mai 1998, pages 70-76, Paul J. Dvorack: "Packaging computers to survive in the real world", qui est un extrait de journal concerne un caisson informatique avec un système de ventilation. Le caisson contient différents appareils mais il ne s'agit pas d'un équipement qui se monte sur une unité centrale de micro-ordinateur. Bien que ce document concerne une circulation d'air, il s'agit simplement d'un système de ventilation et d'isolation phonique mais non d'un accessoire qui se monte sur la sortie d'air d'une unité centrale comme notre invention.

La présente invention a pour but de remédier à ces inconvénients et concerne à cet effet un dispositif de sortie d'air d'une unité centrale de micro-ordinateur, comprenant:
- un support qui se fixe autour de l'orifice de sortie d'air de ventilation du boîtier du micro-ordinateur,
- un tube de guidage relié au support, et
- un filtre à air amovible placé dans le chemin de l'air traversant le support et le tube de guidage.

Le dispositif de l'invention, du genre de celui susvisé, est reconnaissable par le fait que le tube de guidage est relié au support de façon orientable pour permettre de diriger l'air dans une direction désirée, et que le filtre à air étant amovible.

Ce dispositif permet d'orienter le jet d'air de ventilation dans la direction souhaitée; cette orientation peut être modifiée suivant les circonstances.

Le filtre à air amovible retient les poussières, les particules, etc... Il peut être changé par simple enlèvement et être vendu comme accessoire. L'installation du dispositif se fait de manière simple et non définitive. Le support se fixe de manière étanche autour de l'orifice de sortie, en général circulaire, du boîtier du micro-ordinateur. A ce moment II n'est pas nécessaire de tenir compte de l'orientation que l'on veut donner au tube de guidage puisque ce dernier est orientable.

Ce dispositif de sortie d'air a également l'avantage de ne pas intervenir ni sur la fabrication du boîtier, ni sur celle des autres parties du micro-ordinateur. La porosité suffisante du filtre à air permet une bonne ventilation du micro-ordinateur.

Suivant d'autres caractéristiques avantageuses de l'invention:
- le support est formé par un manchon muni d'une bride circulaire portant un adhésif destiné à fixer le support par collage à la paroi du boîtier autour de l'orifice de sortie d'air de ventilation.
- le support est formé d'un anneau adhésif muni d'une surface d'accrochage, cet anneau étant fixé au boîtier autour de l'orifice de sortie d'air et le tube de guidage est muni d'une bride périphérique, garnie d'une surface d'accrochage complémentaire pour être reliée à la surface d'accrochage du support.
- le tube de guidage est formé d'un coude emmanché sur le manchon du support.
- le tube de guidage est muni d'une bride périphérique garnie d'une surface adhésive pour constituer le support fixé directement au boîtier autour de l'orifice de sortie d'air de ventilation.
- le tube de guidage a une section circulaire au niveau de l'orifice de sortie d'air de ventilation et en aval de cette sortie sa section est circulaire, ovale aplatie ou rectangulaire.
- le filtre amovible est constitué par une garniture maintenue sur la sortie du boîtier du micro-ordinateur par le support.
- le filtre à air est une garniture tenue entre le support et le manchon du tube.
- le filtre à air est un élément fixé à la sortie du tube de guidage d'air.
- le tube de guidage d'air se compose d'une première partie munie d'un manchon, qui est fixé sur le manchon du support, et d'une seconde partie emmanchée de manière télescopique sur la première partie du tube.

La présente invention sera décrite ci-après de manière plus détaillée à l'aide de différents exemples de réalisation représentés schématiquement dans les dessins annexés dans lesquels :
- la figure 1 est une vue en coupe partielle de la paroi du boîtier de micro-ordinateur au niveau de la sortie d'air de ventilation, cette paroi étant équipée d'un dispositif de sortie d'air selon un premier mode de réalisation de l'invention,
- la figure 2 est une vue en coupe analogue à celle de la figure 1 correspondant à un second mode de réalisation de l'invention,
- la figure 3 est une vue en coupe analogue à celle de la figure 1 correspondant à un troisième mode de réalisation de l'invention.

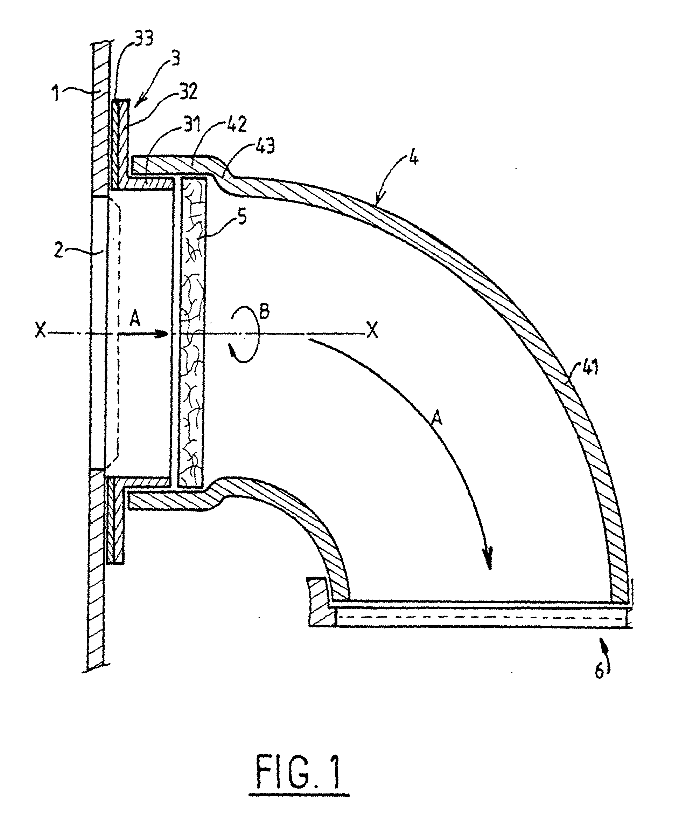

Selon la figure 1, l'invention concerne un dispositif de sortie d'air destiné à se fixer sur la paroi 1 du boîtier d'une unité centrale d'un micro-ordinateur, autour de l'orifice 2 de sortie d'air de ventilation du micro-ordinateur. La circulation de l'air est représentée par les flèches A.

Le dispositif se compose d'un support 3 qui se fixe de manière étanche autour de l'orifice 2. Comme l'orifice 2 est en général de forme circulaire, le support 3 est, selon ce mode de réalisation, une pièce en forme de manchon 31 bordé par une bride périphérique 32 munie d'un moyen de fixation 33, par exemple un adhésif double face qui se colle, d'une part, à la bride 32, et, d'autre part, à la paroi 1. Ce moyen de fixation peut également être constitué par un moyen d'accrochage à griffes, formé de deux parties dont l'une est collée à la paroi 1 et l'autre, à la bride 3. Un joint non représenté, par exemple à l'intérieur du manchon, comme un joint en mousse, assure l'étanchéité.

Le support reçoit sur son manchon 31, un tube de guidage 4 formé d'un coude 41 terminé à l'une de ses extrémités par un manchon 42 destiné à se glisser sur le manchon 31 du support 3. La liaison entre les parties 42, 31 est un simple emmanchement, permettant de diriger la sortie d'air par pivotement du tube de guidage autour de l'axe XX (axe de rotation) dans le sens de la double flèche B. Le tube de guidage peut ainsi être orienté entre la position verticale descendante représentée à la figure 1 et n'importe quelle autre orientation autour de l'axe XX.

Entre l'épaulement 43 formé par la jonction des parties 41 et 42 du tube de guidage 4 et le manchon 31 du support 3, on a placé un filtre 5 en forme de rondelle. Ce filtre a une porosité suffisamment fine pour retenir les poussières et les particules tout en ne créant qu'une perte de charge relativement faible pour ne pas entraver de manière significative la sortie d'air de ventilation.

Ce filtre 5 est monté de manière interchangeable à son emplacement. Pour l'enlever et le remplacer il suffit de dégager le tube de guidage 4.

Il est également possible de prévoir un filtre 6 à la sortie du coude 41 du tube de guidage 4. Ce filtre 6 est alors simplement emmanché ou éventuellement vissé sur l'extrémité du coude 41.

L'accessibilité du filtre est assurée facilement 20 dans les deux cas. Dans le premier cas, le filtre est protégé mécaniquement à l'intérieur du manchon, le filtre s'enlève par simple déboîtage du manchon.

De plus, dans ce cas, le flux d'air est de nouveau régularisé par le manchon en aval du filtre.

Dans le second cas, le filtre est directement accessible sans avoir à enlever le manchon mais la sortie d'air est plus diffuse et moins dirigée.

Dans les deux cas, le filtre changé se remplace comme tout accessoire " consommable "

Cette seconde variante constitue une alternative de la première variante, c'est-à-dire du filtre 5. On peut également prévoir le cas échéant un double filtre en limitant toutefois le maximum autorisé pour les pertes de charge afin de ne pas gêner la circulation d'air de ventilation.

Ce filtre réalisé par exemple en fibres non tissées peut être chargé d'un produit favorisant la retenue des particules, d'un désinfectant ou d'un parfum.

Dans le cas de deux filtres, l'un peut être un filtre à charbon actif.

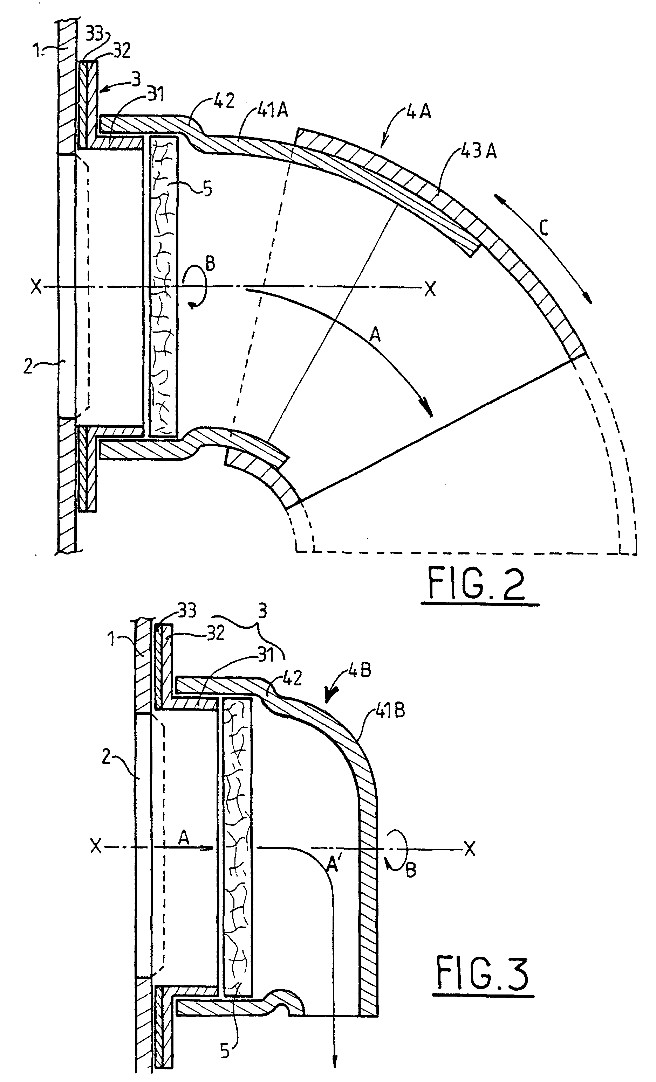

La figure 2 montre une autre variante de réalisation d'un dispositif de sortie d'air. Pour la description de cette figure on a utilisé les mêmes références qu'à la figure 1 pour désigner les parties communes.

Selon ce second mode de réalisation, le dispositif de sortie d'air se fixe comme précédemment sur la paroi 1 d'un boîtier d'une unité centrale d'un micro-ordinateur autour de l'orifice 2 de sortie de l'air de ventilation. Cet orifice est usuellement muni d'une grille. L'air circule dans le sens de la flèche A.

Le dispositif se compose, comme précédemment, d'un support 3 fixé autour de l'orifice 2. Le support se compose d'un manchon 31 et d'une collerette périphérique 32. Cette collerette périphérique est fixée à la paroi 1 de manière amovible par un moyen de fixation 33 tel qu'une bande adhésive double face ou un moyen d'accrochage à griffes.

Le support 3 reçoit le tube de guidage 4A formé d'un manchon 41A de forme coudée, terminé à l'une de ses extrémités par un manchon 42 venant s'engager par-dessus le manchon 31 du support 3 avec interposition éventuelle de la rondelle du filtre à air 5.

Le coude 41A reçoit de manière coulissante un coude 25 de sortie 43A qui peut coulisser sur le coude 41A dans le sens de la double flèche C de manière à modifier la direction du jet de sortie d'air. Cette modification de la direction de sortie se combine alors à l'orientation angulaire autour de l'axe XX (flèche B) comme dans le premier mode de réalisation.

Ce coude extérieur 43A peut également recevoir à son extrémité un embout avec filtre comme le filtre 6 de la figure 1.

Selon la figure 3, le troisième mode de réalisation du dispositif de sortie d'air selon l'invention se distingue du premier mode de réalisation de la figure 1 uniquement par une modification de la forme du coude 41B qui est aplati pour être moins encombrant, tout en ayant une section identique pour ne pas modifier trop fortement la vitesse de circulation de l'air (flèche A'). Les autres parties de ce dispositif de sortie d'air sont identiques à celles du premier mode de réalisation et leur description ne sera pas reprise.

Comme dans le premier mode de réalisation, on peut également prévoir un filtre - (non représenté) en sortie du manchon 41B. Ce filtre aura une section adaptée à celle du coude 41 B du tube de guidage 4B ainsi modifié.

## Revendications

1. Dispositif de sortie d'air d'une unité centrale de micro-ordinateur, comprenant :
- un support (3) qui se fixe autour de l'orifice (2) de sortie d'air de ventilation du boîtier du micro-ordinateur,
- un tube de guidage (4, 4A, 4B) relié au support (3), et
- un filtre à air (5, 6) placé dans le chemin de l'air traversant le support (3) et le tube de guidage (4, 4A, 4B),
**caractérisé:**
**en ce que** le tube de guidage (4,4A,4B) est relié au support (3) de façon orientable pour permettre de diriger l'air dans une direction désirée, et
**en ce que** le filtre d'air (5,6) est amovible.

2. Dispositif selon la revendication 1,
**caractérisé en ce que**
le support (3) est formé par un manchon (31) muni d'une bride circulaire (32) portant un adhésif (33) destiné à fixer le support (3) par collage à la paroi (1) du boîtier autour de l'orifice (2) de sortie d'air de ventilation.

3. Dispositif selon la revendication 1,
**caractérisé en ce que**
le support (3) est formé d'un anneau adhésif muni d'une surface d'accrochage, cet anneau étant fixé au boîtier autour de l'orifice de sortie d'air et le tube de guidage (4) est muni d'une bride périphérique, garnie d'une surface d'accrochage complémentaire pour être reliée à la surface d'accrochage du support.

4. Dispositif selon la revendication 1,
**caractérisé en ce que**
le tube de guidage (4) est formé d'un coude emmanché (42) sur le manchon (31) du support (3).

5. Dispositif selon la revendication 1,
**caractérisé en ce que**
le tube de guidage (4) est muni d'une bride périphérique garnie d'une surface adhésive pour constituer le support fixé directement au boîtier (1) autour de l'orifice (2) de sortie d'air de ventilation.

6. Dispositif selon la revendication 1,
**caractérisé en ce que**
le tube de guidage (4, 4A, 4B) a une section circulaire au niveau de l'orifice (2) de sortie d'air de ventilation et en aval de cette sortie sa section est circulaire (4, 4A), ovale aplatie ou rectangulaire (4P)

7. Dispositif selon la revendication 1,
**caractérisé en ce que**
le filtre amovible (5) est constitué par une garniture maintenue sur la sortie du boîtier du micro-ordinateur par le support (3).

8. Dispositif selon la revendication 1,
**caractérisé en ce que**
le filtre à air (5) est une garniture tenue entre le support (3) et le manchon (42) du tube (4, 4A, 4B)

9. Dispositif selon la revendication 1,
**caractérisé en ce que**
le filtre à air (5) est un élément fixé à la sortie du tube de guidage d'air.

10. Dispositif selon la revendication 1,
**caractérisé en ce que**
le tube de guidage d'air (4A) se compose d'une première partie (41A) munie d'un manchon (42), qui est fixé sur le manchon (31) du support (3), et d'une seconde partie (43A) emmanchée de manière télescopique sur la première partie (41A) du tube (4A).

## Patentansprüche

1. Luftauslassvorrichtung für einer Mikrocomputer-Zentraleinheit mit:
- einem Träger (3), der sich um die Öffnung (2) des Ventilationsluftausganges des Gehäuses des Mikrocomputers befestigt ist,
- einer mit dem Träger (3) verbundene Führungsröhre (4, 4A, 4B), und
- einem auf der den Träger (3) und die Führungsröhre (4, 4A, 4B) durchquerenden Luftstrecke liegenden Luftfilter (5,6),
**dadurch gekennzeichnet,**
**dass** die Führungsröhre (4,4A,4B) mit dem Träger (3) so drehbar verbunden ist, dass es möglich ist, die Luft in eine gewünschte Richtung zu leiten, und **dadurch gekennzeichnet, dass** der Luftfilter (5,6) abnehmbar ist.

2. Vorrichtung nach Anspruch 1, **dadurch gekennzeichnet, dass** der Träger (3) durch eine mit einem kreisförmigen Flansch (32) ausgestattete Muffe (31) gebildet ist, die einen Klebstoff (33) zur Befestigung des Trägers (3) durch Klebung an der Wand (1) des Gehäuses um die Öffnung (2) des Ventilationsluftausgangs enthält.

3. Vorrichtung nach Anspruch 1, **dadurch gekennzeichnet, dass** der Träger (3) durch einen mit einer Haftungsoberfläche ausgestatteten klebenden Ring gebildet ist, wobei dieser Ring an dem Gehäuse um die Öffnung des Luftausgangs befestigt ist und die Führungsröhre (4) mit einem Außenflansch ausgestattet ist, der von einer entsprechenden Haftungsoberfläche umgeben ist, um mit der Haftungsoberfläche des Trägers verbunden zu werden.

4. Vorrichtung nach Anspruch 1, **dadurch gekennzeichnet, dass** die Führungsröhre (4) durch eine auf die Muffe (31) des Trägers (3) aufgesetzte Krümmung (42) gebildet ist.

5. Vorrichtung nach Anspruch 1, **dadurch gekennzeichnet, dass** die Führungsröhre (4) mit einem zur Bildung des Trägers direkt am Gehäuse (1) um die Öffnung des Ventilationsluftausgangs von einer klebenden Oberfläche umgebenen Außenflansch ausgestattet ist.

6. Vorrichtung nach Anspruch 1, **dadurch gekennzeichnet, dass** die Führungsröhre (4, 4A, 4B) auf der Höhe der Öffnung (2) des Ventilationsluftausganges unterhalb dieses Ausganges einen kreisförmigen (4, 4A), oval abgeflachten oder rechteckigen (4P) Abschnitt hat.

7. Vorrichtung nach Anspruch 1, **dadurch gekennzeichnet, dass** der abnehmbare Luftfilter (5) aus einer auf dem Gehäuseluftausgang des Mikrocomputers vom Träger (3) gehaltenen Ummantelung besteht.

8. Vorrichtung nach Anspruch 1, **dadurch gekennzeichnet, dass** der Luftfilter (5) eine zwischen dem Träger (3) und der Muffe (42) der Röhre (4, 4A, 4B) gehaltene Ummantelung ist.

9. Vorrichtung nach Anspruch 1, **dadurch gekennzeichnet, dass** der Luftfilter (5) ein an dem Luftausgang der Führungsröhre befestigtes Element ist.

10. Vorrichtung nach Anspruch 1, **dadurch gekennzeichnet, dass** sich die Luftführungsröhre (4A) aus einem ersten, mit einer auf der Muffe (31) des Trägers (3) befestigten Muffe (42) ausgestatteten Teil (41A), und aus einem zweiten, teleskopisch auf den ersten Teil (41A) der Röhre (4A) aufgesetzten Teil (43A) zusammensetzt.

## Claims

1. An air outlet device for a microcomputer CPU, comprising:
- a holder (3) which is fixed around the ventilation air outlet (2) of the microcomputer housing,
- a guiding tube (4, 4 A, 4 B) linked to the holder (3), and
- an air filter (5, 6) placed in the pathway of the air crossing the holder (3) and the guiding tube (4, 4 A, 4 B),
**characterised:**
**in that** the guiding tube (4, 4 A, 4 B) is linked to the holder (3) in a removable way to allow directing the air in the desired direction, and in that the air filter (5, 6) is removable.

2. A device according to Claim 1, **characterised in that** the holder (3) is formed by a coupling (31) supplied with a circular bracket (32) carrying an adhesive (33) destined to fasten the holder (3) by sticking it to the wall (1) of the housing around the ventilation air outlet (2).

3. A device according to Claim 1, **characterised in that** the holder (3) is formed by an adhesive ring supplied with a coupling surface, said ring being fastened to the housing around the outlet orifice of air and the guiding tube (4) is supplied with a peripheral bracket that has a complementary coupling surface to be linked to the coupling surface of the holder.

4. A device according to Claim 1, **characterised in that** the guiding tube (4) is formed by a bend (42) coupled on the coupling (31) of the holder (3).

5. A device according to Claim 1, **characterised in that** the guiding tube (4) is supplied with a peripheral bracket that has an adhesive surface to constitute the holder fastened directly to the housing (1) around the ventilation air outlet (2).

6. A device according to Claim 1, **characterised in that** the guiding tube (4, 4 A, 4 B) has a circular section at the level of the ventilation air outlet (2) and below this outlet its section is circular (4, 4 A), oval flattened, or rectangular (4P).

7. A device according to Claim 1, **characterised in that** the removable filter (5) is constituted by a packing kept on the outlet of the microcomputer's housing by the holder (3).

8. A device according to Claim 1, **characterised in that** the air filter (5) is a packing kept between the holder (3) and the coupling (42) of the tube (4, 4 A, 4 B).

9. A device according to Claim 1, **characterised in that** the air filter (5) is an element fastened to the air guiding tube outlet.

10. A device according to Claim 1, **characterised in that** the air guiding tube (4 A) comprises a first part (41 A) supplied with a coupling (42), which is fastened on the coupling (31) of the holder (3), and a second part (43 A) coupled in a telescopic way on the first part (41 A) of the tube (4 A).
